# EUROPÄISCHE PATENTSCHRIFT

(11) **EP 1 190 264 B1**
(45) Veröffentlichungstag und Bekanntmachung des Hinweises auf die Patenterteilung: **19.01.2005**
(21) Anmeldenummer: 00927200.6
(22) Anmeldetag: 12.05.2000
(51) Int. Cl.: G01R 31/30, G11C 29/00

(54) **INTEGRIERTE SCHALTUNG UND VERFAHREN ZUM BESTIMMEN DER STROMERGIEBIGKEIT EINES SCHALTUNGSTEILS DER INTEGRIERTEN SCHALTUNG**
INTEGRATED CIRCUIT AND METHOD FOR DETERMINING THE CURRENT YIELD OF A PART OF THE INTEGRATED CIRCUIT
CIRCUIT INTEGRE ET PROCEDE PERMETTANT DE DETERMINER LA PRODUCTIVITE DE COURANT D'UNE PARTIE DU CIRCUIT INTEGRE

(30) Priorität: 14.05.1999 EP 99109647
(43) Veröffentlichungstag der Anmeldung: 27.03.2002
(73) Patentinhaber: Infineon Technologies AG, 81669 München (DE)
(72) Erfinder: WEDER, Uwe, D-84072 Au/Hallertau (DE)
(74) Vertreter: Epping Hermann & Fischer
(86) Internationale Anmeldenummer: PCT/EP2000/004318
(87) Internationale Veröffentlichungsnummer: WO 2000/070359

(56) Entgegenhaltungen:
- EP-A- 0 616 335
- FR-A- 2 760 888

## Beschreibung

Integrierte Schaltungen bestehen zumeist aus Schaltungsteilen, die von anderen Schaltungsteilen angesteuert werden und ihrerseits wieder andere ansteuern. Ein Maß für die sichere und eindeutige Ansteuerung einer Anzahl nachfolgender Schaltungsteile ist die Stromergiebigkeit eines Schaltungsteils. Diese läßt sich oftmals nachträglich durch Kalibrierung bestimmter Ansteuersignale auf einen gewünschten Wert einstellen, so daß herstellungsprozeßbedingte Schwankungen ausgeglichen werden können. Als Beispiel sollen hier nicht-flüchtige Speicherzellen wie etwa EEPROM-Zellen genannt werden, deren Stromergiebigkeit sich über den Lesespannungspegel in bestimmten Grenzen einstellen läßt.

Um nun eine solche Einstellung beziehungsweise Kalibierung vornehmen zu können, ist es nötig, die Stromergiebigkeit des betreffenden Schaltungsteils, beispielsweise einer EEPROM-Zelle, vorab zu messen.

Diese Messung muß aber relativ genau erfolgen. Eine genaue chipinterne Strommessung ist auf einfachem Weg jedoch nicht möglich, da zwar eine Spannungsreferenz halbleitermaterialspezifisch inhärent in Form der Bandgapspannung existiert, jedoch eine inhärente Stromreferenz für Halbleitermaterial nicht existiert. Eine Stromreferenz könnte damit On-Chip nur aus der zwar genauen Spannungsreferenz und einem allerdings ungenauen On-Chip-Widerstand abgeleitet werden.

Die Messung könnte auch von außerhalb des Halbleiterchips mit genauen Meßgeräten erfolgen. Hierfür sind jedoch zusätzliche Anschlüsse beziehungsweise Pads nötig oder modifizierte Anschlüsse, die zwischen einem Test- und einem Normalbetriebsmodus umschaltbar sind.

Speziell bei Chipkartenanwendungen ist man jedoch bestrebt, die Chipfläche möglichst klein zu halten, um die Bruchfestigkeit des Chips möglichst groß zu halten, so daß zusätzliche Anschlüsse nachteilig sind. Außerdem haben zusätzliche oder modifizierte Anschlüsse prinzipiell den Nachteil, daß sie im Normalbetrieb nicht benötigt werden beziehungsweise umgeschaltet und somit mißbräuchlich benutzt werden können, was besonders bei sicherheitskritischen Chipkartenanwendungen unerwünscht ist.

Aus der FR-A-2 760 888 ist eine integrierte Schaltung bekannt mit einem Schaltungsteil mit variabler Stromergiebigkeit, einer Referenzstromquelle und einer Vergleichseinrichtung, der die Ströme des Schaltungsteils und der Referenzstromquelle zugeführt sind und die detektiert, ob der Referenzstrom höher oder niedriger ist als der Strom des Schaltungsteils. Weiterhin ist ein Verfahren zum Bestimmen der Stromergiebigkeit des Schaltungsteils der integrierten Schaltung beschrieben.

Es ist daher die Aufgabe der Erfindung, eine integrierte Schaltung und ein Verfahren zum Bestimmen der Stromergiebigkeit eines Schaltungsteils der integrierten Schaltung anzugeben, bei der beziehungsweise mit dem eine einfache, jedoch hinreichend genaue Bestimmung der Stromergiebigkeit möglich ist.

Die Aufgabe wird durch eine integrierte Schaltung gemäß Anspruch 1 beziehungsweise ein Verfahren gemäß Anspruch 8 gelöst. Vorteilhafte Weiterbildungen sind in den Unteransprüchen angegeben.

Gemäß der Erfindung wird die Stromergiebigkeit eines Schaltungsteils also indirekt bestimmt. Die Erfindung macht sich hierbei die Tatsache zunutze, daß übliche Eingangs- oder Ausgangsanschlüsse integrierter Schaltungen mit unter bestimmter Beschaltung als Stromquellen wirkenden PMOS- oder NMOS-Transistoren versehen sind.

Bei Ausgangsanschlüssen sind dies die Pull-up- und Pull-down-MOS-Transistoren der Ausgangstreiber. An Eingangsanschlüssen sind üblicherweise entweder ein PMOS-Transistor, der mit seinem Sourceanschluß an der Versorgungsspannung und mit seinem Gateanschluß an Masse liegt, oder ein NMOS-Transistor, dessen Sourceanschluß mit Masse und dessen Gateanschluß mit der Versorgungsspannung des Halbleiterchips verbunden ist, jeweils mit ihrem Drainanschluß angeordnet. Diese Transistoren sind zwar in den leitenden Zustand geschaltet, haben jedoch einen so großen Durchlaßwiderstand, daß sie kaum störend wirken, wenn der betreffende Eingangsanschluß mit einem logischen Pegel beaufschlagt ist. Sie ziehen jedoch trotzdem den Eingang nachfolgender Schaltungen auf einen definierten Pegel, wenn der Eingangsanschluß nicht beschaltet ist, so daß bei CMOS-Schaltungen keine Querströme fließen können.

Werden nun die Eingangs- oder Ausgangsanschlüsse auf Versorgungsspannungspotential oder Masse gelegt, so wirken diese Transistoren wie Stromquellen, deren Stromergiebigkeit am jeweiligen Anschluß von außen meßbar ist.

Die Erfindung macht sich des weiteren die Tatsache zunutze, daß in integrierten Schaltungen absolute Werte wie beispielsweise die Länge und Weite eines Transistorkanals nur schwer exakt einstellbar sind, das Verhältnis der Längen und Weiten verschiedener Transistorkanäle jedoch sehr genau einstellbar ist.

Gemäß der Erfindung werden eine Anzahl von Referenzstromquellen mit Stromergiebigkeiten, die zur Stromergiebigkeit zumindest einer der Stromquellen an einem Eingangs- oder Ausgangsanschluß ein definiertes Verhältnis haben, auf dem Halbleitechip als Teil der integrierten Schaltung vorgesehen. Dies wird in der Praxis durch ein definiertes Gatelängen- und/oder Gateweitenverhältnis der die Stromquellen bildenden MOS-Transistoren erreicht.

Durch Vergleich der Stromergiebigkeiten der Referenzstromquellen mit der Stromergiebigkeit des zu messenden Schaltungsteils sowie durch externe Messung der Stromergiebigkeit der Stromquelle an dem dafür vorgesehenen Eingangs- oder Ausgangsanschluß kann dann die Stromergiebigkeit des Schaltungsteils sehr genau bestimmt werden.

Die Genauigkeit hängt von der tatsächlichen Anzahl der Referenzstromquellen ab, da hierdurch die Meßgenauigkeit der durch sie gebildeten Meßvorrichtung eingestellt werden kann. Es wird dabei in der Praxis ein Kompromiß zwischen-dem Wunsch nach möglichst hoher Meßgenauigkeit, aber auch möglichst geringem Flächenbedarf gefunden werden müssen.

Die Randwerte der eingestellten Stromergiebigkeiten der Referenzstromquellen werden durch die Grenzen der Einstellbarkeit beziehungsweise Kalibrierbarkeit des Schaltungsteils bestimmt sein. Wenn ein zu messendes Schaltungsteil nur in einem bestimmten Bereich einstellbar ist, ist es - ebenfalls aus Gründen der Einsparung von Chipfläche - nicht sinnvoll, die Stromergiebigkeit außerhalb dieses Bereichs zu messen und dafür Referenzstromquellen in der Meßvorrichtung vorzusehen.

Der Vergleich der Stromergiebigkeiten der Referenzstromquellen mit der Stromergiebigkeit des zu messenden Schaltungsteils erfolgt durch Vergleich der Ströme mittels einer Vergleichereinrichtung. Die Messung des Stroms des Schaltungsteils kann prinzipiell von einem für den Betrieb der integrierten Schaltung vorgesehen Schaltungsteil erfolgen, wird normalerweise jedoch an einer speziell dafür vorgesehenew On-Chip-Nachbildung des Schaltungsteils vorgenommen werden unter der Annahme, daß diese Nachbildung in etwa die gleichen Eigenschaften aufweist. Es ist auch denkbar, mehrere Nachbildungen vorzusehen und einen Mittelwert aus der Gesamtheit der Meßergebnisse zu bilden.

Das Schaltungsteil, die Nachbildung oder die Mehrzahl von Nachbildungen kann dabei mit dem einen Eingang eines Vergleichers verbunden sein, während die einzelnen Stromquellen sukzessive an den anderen Eingang geschaltet werden. Das jeweilige Vergleichsergebnis wird beispielsweise durch Einschreiben in einen Speicher festgehalten. Es kann aber auch sofort über einen Ausgangsanschluß nach außen übertragen werden. Aus der Kenntnis des Meßergebnisses an einem Eingang- oder Ausgangsanschluß, der Kenntnis der Stromquelle, deren Stromergiebigkeit höher und der, deren Stromergiebigkeit niedriger als die des Meßobjekts ist sowie dem Verhältnis der Stromergiebigkeiten, läßt sich dann auf einfache Weise sehr genau die Stromergiebigkeit des Schaltungsteils ermitteln.

Statt der Mittelwertbildung der Stromergiebigkeit eines Schaltungsteils durch Parallelschaltung mehrere Schaltungsteilnachbildungen und Teilung des Stroms läßt sich eine Mittelwertbildung auch dadurch erreichen, daß jede Referenzstromquelle mit einer unterschiedlichen Nachbildung des zu messenden Schaltungsteils verglichen wird. Dies kann mit nur einer Vergleichereinrichtung, an die die zu vergleichenden Paare sukzessive angeschaltet werden, aber auch mit mehreren Vergleichereinrichtungen - für jedes Schaltungsteil-Stromquellen Paar eine - erfolgen.

Eine besonders einfache Ausführungsform sieht vor, daß bei einer Pull-Down-Charakteristik des Schaltungsteils - beispielsweise einer n-Kanal-EEPROM-Zelle - dieses direkt mit einer Stromquelle mit Pull-Up-Charakteristik, also beispielsweise einem PMOS-Transistor, dessen Gateanschluß auf Masse liegt, verbunden wird. Der Verbindungspunkt wird mit einem Vergleicher verbunden, dem entweder ein Referenzpotential zugeführt wird oder der aufgrund seines Aufbaus eine innere Referenz hat wie beispielsweise ein CMOS-Inverter.

Die Erfindung wird nachfolgend anhand von Ausführungsbeispielen mit Hilfe von Figuren näher erläutert. Dabei zeigen:
- Figur 1: ein sehr schematisches Prinzipschaltbild einer erfindungsgemäßen integrierten Schaltung,
- Figur 2: ein erstes Ausführungsbeispiel mit nur einem zu messenden Schaltungsteil, und
- Figur 3: ein zweites Ausführungsbeispiel mit mehreren Schaltungsteilnachbildungen zur Mittelwertbildung.

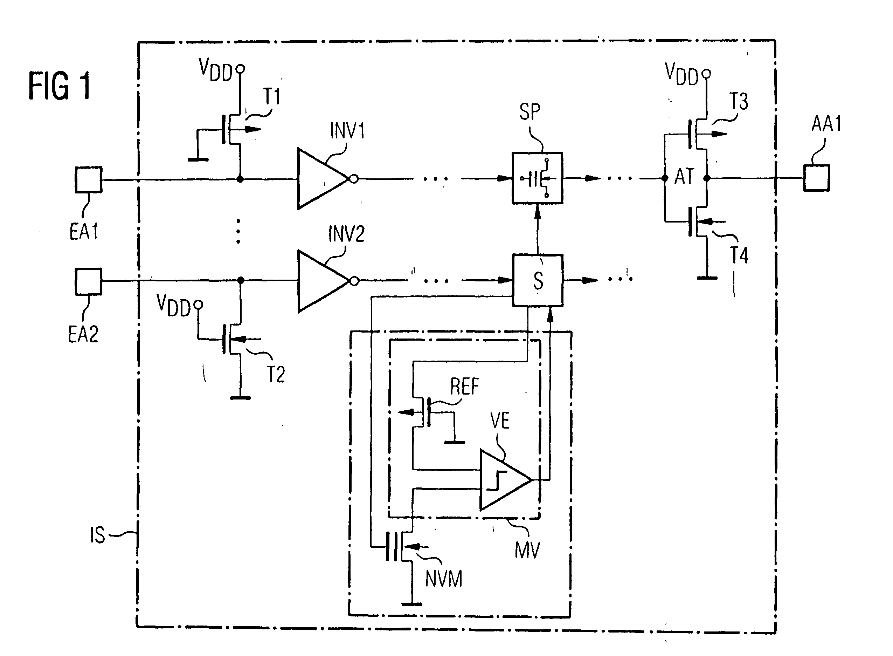

Figur 1 zeigt in sehr schematischer Weise eine integrierte Schaltung IS mit im dargestellten Beispiel zwei Eingangsanschlüssen EA1, EA2 sowie einem Ausgangsanschluß AA1. Das dargestellte Beispiel ist in CMOS-Schaltungstechnik ausgeführt, die Erfindung läßt sich jedoch in beliebigen Schaltungstechniken anwenden. Die Eingangsanschlüsse EA1, EA2 führen im dargestellten Beispiel auf Inverterschaltungen INV1 und INV2. Um einen Querstrom in diesen Inverterschaltungen INV1, INV2 bei unbeschalteten Eingangsanschlüssen EA1, EA2 zu vermeiden, sind an den Eingängen der Inverterschaltungen INV1, INV2 leitend geschaltete hochohmige Transistoren T1, T2 angeordnet. Es kommen hierbei sowohl PMOS- als auch NMOS-Transistoren in Frage, was im dargestellten Beispiel dadurch herausgestellt wird, daß am ersten Inverter INV1 ein PMOS-Transistor T1 und am zweiten Inverter INV2 ein NMOS-Transistor T2 angeordnet ist.

Ausgangsanschlüsse integrierter Schaltungen werden meistens von Ausgangstreibern angesteuert. Im dargestellten Beispiel einer integrierten Schaltung IS in Figur 1 ist der Ausgangsanschluß AA1 mit dem Ausgang eines mit zwei Transistoren T3 und T4 gebildeten Ausgangstreibers AT verbunden.

Wenn der erste Eingangsanschluß EA1 auf Masse gelegt wird, wird der erste Transistor T1 leitend geschaltet und der von ihm gelieferte Strom läßt sich am ersten Eingangsanschluß EA1 messen. In gleicher Weise läßt sich der Strom des Transistors T2 messen, wenn der zweite Eingangsanschluß EA2 auf Versorgungsspannungspotential geschaltet wird. Abhängig davon, ob der Ausgangsanschluß AA1 auf Masse oder auf Versorgungsspannungspotential VDD geschaltet wird, läßt sich entweder die Stromergiebigkeit des Transistors T3 des Ausgangstreiber AT oder die Stromergiebigkeit des Transistors T4 des Ausgangstreibers AT messen.

In der Figur 1 ist als Bestandteil der integrierten Schaltung IS des weiteren als Schaltungsteil, dessen Stromergiebigkeit zu bestimmen ist, ein nicht-flüchtiger Speicher SP angedeutet. Um die Stromergiebigkeit einer Speicherzelle des Speichers SP bestimmen zu können, ist eine Nachbildung NVM einer Speicherzelle des Speichers SP vorgesehen. Des weiteren ist in erfindungsgemäßer Weise eine Referenzstromquelle REF in Form eines durchgeschalteten PMOS-Transistors vorgesehen, dessen Ausgangsanschluß in gleicher Weise wie der Ausgangsanschluß der nicht-flüchtigen Speicherzelle NVM mit einem Eingang einer Vergleichereinrichtung VE verbunden ist. Sowohl der Steuergate-Anschluß der nicht-flüchtigen Speicherzelle NVM als auch der Sourceanschluß der Referenzstromquelle REF werden von einer Steuerschaltung S mit geeigneten Signalen beaufschlagt. Der Ausgangsanschluß der Vergleichereinrichtung VE wird im dargestellten Beispiel ebenfalls zur Auswertung der Steuerschaltung S zugeführt. Die Referenzstromquelle REF und die Vergleichereinrichtung VE bilden die Meßvorrichtung MV. Die Referenzstromquelle REF ist als durchgeschalteter PMOS-Transistor ausgebildet, wobei die Kanalweite und/oder Länge in einem definierten Verhältnis zur Kanalweite und/oder Länge entweder zum Transistor T1 am Eingangsanschluß 1 oder zum PMOS-Transistor T3 am-Ausgangsanschluß AA1 steht.

Aufgrund dieses bekannten Verhältnisses läßt sich durch Messung der Stromergiebigkeit des PMOS-Transistors T1 am Eingangsanschluß EA1 beziehungsweise des PMOS-Transistors T3 am Ausgangsanschluß AA1 die Stromergiebigkeit der Referenzstromquelle REF ermitteln und aufgrund der Vergleichereinrichtung VE messen, ob die Stromergiebigkeit der nicht-flüchtigen Speicherzelle NVM größer oder kleiner ist als die der Referenzstromquelle REF.

Der Vergleich mit nur einer Referenzstromquelle REF bringt als Ergebnis jedoch nur, daß die Stromergiebigkeit der zu messenden nicht-flüchtigen Speicherzelle MVM größer oder kleiner als die Stromergiebigkeit der Referenzstromquelle ist. Um die Meßgenauigkeit zu erhöhen, müssen eine größere Anzahl von Referenzstromquellen vorgesehen werden.

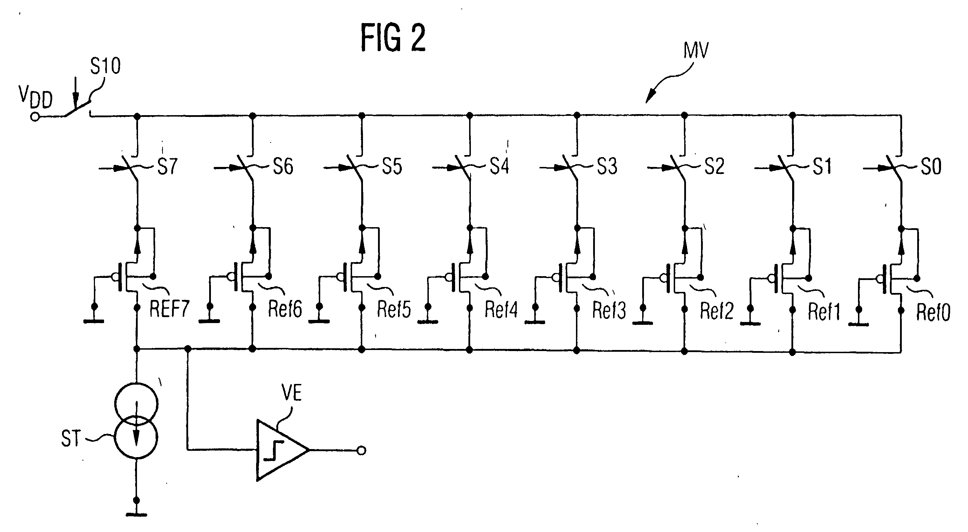

Eine Meßvorrichtung MV mit in der Praxis in den meisten Fällen ausreichender Meßgenauigkeit ist in Figur 2 mit acht Referenzstromquellen REF0 bis REF7 dargestellt. Diese sind im dargestellten Ausführungsbeispiel ebenfalls mit PMOS-Transistoren gebildet, deren Gateanschlüsse mit Masse verbunden sind. Die Sourceanschlüsse dieser PMOS-Transistoren sind über Schalter S0 bis S7 über einen weiteren Schalter S10 mit dem Versorgungsspannungsanschluß VDD schaltbar. Die Ansteuerbarkeit der Schalter S0 bis S7, S10 ist durch Pfeile angedeutet und erfolgt beispielsweise über die Steuerschaltung S aus Figur 1.

Die Drainanschlüsse der Referenzstromquellen REF0 bis REF7 sind miteinander und mit dem Eingang einer Vergleichereinrichtung VE verbunden. Das zu messenden Schaltungsteil ST ist in Figur 2 als Stromquelle dargestellt, deren Stromergiebigkeit bestimmt werden soll. Dieses Schaltungsteil ST kann dabei durch ein einzelnes Schaltungsteil gebildet sein, aber auch durch die Parallelschaltung mehrerer Schaltungsteile, um einen Mittelwert zu bilden. Hierbei muß dann der Ausgangsstrom der parallel geschalteten Schaltungsteile entweder entsprechend der Anzahl der parallel geschalteten Schaltungsteile heruntergeteilt werden oder die Stromergiebigkeit der Referenzstromquellen REF0 bis REF7 entsprechend angepaßt sein. Der Ausgang des Schaltungsteils ST ist ebenfalls mit dem Eingang der Vergleichereinrichtung VE verbunden.

Die Referenzstromquellen REF0 bis REF7 weisen unterschiedliche Stromergiebigkeiten auf, wobei beispielsweise die Stromquelle REF4 eine Stromergiebigkeit aufweist, die in etwa der erwarteten Stromergiebigkeit des Schaltungsteils ST entspricht und die Stromergiebigkeiten der anderen Referenzstromquellen gegenüber der benachbarten um etwa 5% dieses Nominalwerts ansteigen oder abfallen.

Die Messung erfolgt nun dadurch, daß zunächst im Testmodus der Schalter S10 geschlossen wird und damit eine Spannungsversorgung an die Meßvorrichtung MV angelegt wird. Danach wird sukzessive jeweils einer der Schalter S0 bis S7 geschlossen und auf diese Weise ermittelt, ob die Stromergiebigkeit des Schaltungsteils ST größer oder kleiner als die Stromergiebigkeit der jeweils angeschalteten Referenzstromquelle REF0 bis REF7 ist. Dies wird durch einen High- oder Low-Zustand am Ausgang der Vergleichereinrichtung VE angezeigt. Je nachdem, ob der auf diese Weise gemessene Wert der Stromergiebigkeit für das Schaltungsteil ST größer oder kleiner als der erwartete Wert ist, kann durch entsprechende Variation beispielsweise der Lesespannung einer nicht-flüchtigen Speicherzelle der gewünschte Wert eingestellt werden.

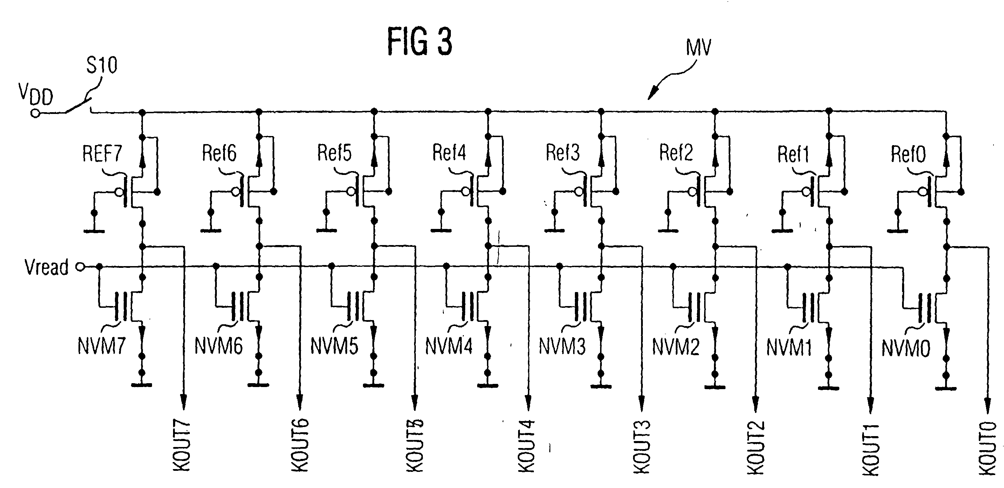

Eine weitere Möglichkeit zur Mittelwertbildung der Stromergiebigkeit von zu messenden Schaltungsteilen ist in Figur 3 am Beispiel von EEPROM-Zellen dargestellt. Die Meßvorrichtung INV weist wiederum acht Referenzstromquellen REF0 bis REF7 auf, deren Ausgänge direkt mit den Ausgängen jeweiliger nicht-flüchtiger Speicherzelle NVM0 bis NVM7 verbunden sind. Die Steuergateeingänge der nicht-flüchtigen Speicherzelle NVM0 bis NVM7 sind mit einem Anschluß für einen Lesespannungspegel VREAD verbunden. Die Verbindungspunkte der jeweiligen Stromquellen-Speicherzellenpaare bilden Anschlüsse KOUT0 bis KOUT7. Diese können jeder für sich mit dem Eingang einer jeweiligen Vergleichereinrichtung verbunden werden oder sukzessive mit dem Eingang einer einzigen Vergleichereinrichtung beispielsweise über ansteuerbare Schalter.

Die erfindungsgemäße integrierte Schaltung sowie das erfindungsgemäße Verfahren bilden eine einfache Möglichkeit der On-Chip-Strommessung. Der dafür nötige Schaltungsaufwand ist sehr gering und erfordert für die in den Figuren 2 und 3 dargestellten Ausführungsbeispielen weniger Chipfläche als ein zusätzliches Anschlußpad.

## Patentansprüche

1. Integrierte Schaltung (IS) mit zumindest einem Schaltungsteil (ST; NVM; NVM0...NVM7), dessen Stromergiebigkeit einstellbar ist, mit einer Referenzstromquelle und einer Vergleichereinrichtung, **dadurch gekennzeichnet, daß**
- an einem Eingangs- (EA1, EA2) oder Ausgangsanschluß (AA1) der integrieren Schaltung (IS) zumindest eine Stromquelle (T1, T2, T3, T4) angeordnet ist, deren Stromergiebigkeit von außerhalb der integrierten Schaltung (IS) meßbar ist,
- eine Meßvorrichtung (MV) vorgesehen ist, die eine durch die gewünschte Meßgenauigkeit bestimmte Anzahl von Referenzstromquellen aufweist, deren Stromergiebigkeiten unterschiedlich sind, jedoch in einem definierten Verhältnis zur Stromergiebigkeit der an einem Eingangs- (EA1, EA2) oder Ausgangsanschluß (AA1) angeordneten Stromquellen (T1, T2, T3, T4) stehen, wobei die Meßvorrichtung (MV) außerdem die zumindest eine Vergleichereinrichtung (VE) aufweist, der sowohl der Strom des Schaltungsteils (ST; NVM; NVM0...NVM7) als auch die Ströme der Referenzstromquellen (REF; REF0...REF7) zuführbar sind und die derart ausgebildet ist, daß sie detektiert, welche der Referenzstromquellen (REF; REF0...REF7) eine höhere oder eine niedrigere Stromergiebigkeit aufweist als das Schaltungsteil (ST; NVM; NVM0...NVM7).

2. Integrierte Schaltung nach Anspruch 1, **dadurch gekennzeichnet, daß** eine der Referenzstromquellen (REF4) eine Stromergiebigkeit aufweist, die etwa der erwarteten Stromergiebigkeit des zu messenden Schaltungsteils (ST; NVM0...NVM7) entspricht und zwei weitere Referenzstromquellen (REF0, REF7) Stromergiebigkeiten aufweisen, die etwa der oberen und der unteren Grenze der Einstellbarkeit des Schaltungsteils (ST; NVM0...NVM7) entsprechen und die Stromergiebigkeit der weiteren Referenzstromquellen (REF1, REF2, REF3, REF5, REF6) Werte haben, die zwischen diesen Grenzwerten liegen.

3. Integrierte Schaltung nach Anspruch 1 oder 2, **dadurch gekennzeichnet,**
**daß** die an einem Eingangsanschluß (EA1, EA2) angeordnete Stromquelle ein PMOS-Transistor (T1) ist, dessen Sourceanschluß mit der Versorgungsspannung (VDD), dessen Gateanschluß mit Masse und dessen Drainanschluß mit dem Eingangsanschluß (EA1) verbunden ist und
**daß** die Referenzstromquellen (REF0...REF7) ebenfalls PMOS-Transistoren sind, deren jeweilige Sourceanschlüsse mit der Versorgungsspannung (VDD) verbindbar und deren jeweilige Gateanschlüsse mit Masse verbunden sind und deren jeweilige Drainanschlüsse die Ausgänge der Referenzstromquellen (REF0...REF7) bilden.

4. Integrierte Schaltung nach Anspruch 1 oder 2, **dadurch gekennzeichnet,**
**daß** die an einem Eingangsanschluß (EA2) angeordnete Stromquelle ein NMOS-Transistor (T2) ist, dessen Sourceanschluß mit Masse, dessen Gateanschluß mit der Versorgungsspannung (VDD) und dessen Drainanschluß mit dem Eingangsanschluß (EA2) verbunden ist und
**daß** die Referenzstromquellen (REF0...REF7) ebenfalls NMOS-Transistoren sind, deren jeweilige Sourceanschlüsse mit Masse verbindbar und deren jeweilige Gateanschlüsse mit der Versorgungsspannung (VDD) verbunden sind und deren jeweilige Drainanschlüsse die Ausgänge der Referenzstromquellen (REF0...REF7) bilden.

5. Integrierte Schaltung nach Anspruch 1 oder 2, **dadurch gekennzeichnet, daß** die an einem Ausgangsanschluß (AA1) angeordnete Stromquelle der PMOS- (T3) oder der NMOS-Transistor (T4) eines CMOS-Ausgangstreibers (AT) ist und daß die Referenzstromquellen (REF0...REF7) ebenfalls PMOS- bzw. NMOS-Transistoren sind, deren jeweilige Sourceanschlüsse mit der Versorgungsspannung (VDD) bzw. mit Masse verbindbar und deren jeweilige Gateanschlüsse mit Masse bzw. mit-der Versorgungsspannung (VDD) verbunden sind und deren jeweilige Drainanschlüsse die Ausgänge der Referenzstromquellen (REF0...REF7) bilden.

6. Integrierte Schaltung nach einem der Ansprüche 1 bis 5,
**dadurch gekennzeichnet,**
**daß** das Schaltungsteil (ST) durch eine Anzahl identischer, parallel geschalteter Schaltungsteil-Nachbildungen gebildet ist, deren stromliefernder Ausgang über einen den Strom durch die Anzahl teilenden Stromteiler mit der Vergleichereinrichtung (VE) verbindbar ist.

7. Integrierte Schaltung-nach einem der Ansprüche 1 bis 5,
**dadurch gekennzeichnet,**
**daß** jeder der Referenzstromquellen (REF0...REF7) eine unterschiedliche Schaltungsteil-Nachbildung (NVM0...NVM7) zugeordnet ist.

8. Verfahren zum Bestimmen der Stromergiebigkeit zumindest eines Schaltungsteils (ST) einer integrierten Schaltung (IS) mit den Schritten:
a) Messen der Stromergiebigkeit einer an einem Eingangs- (EA1, EA2) oder Ausgangsanschluß (AA1) der integrierten Schaltung angeordneten Stromquelle (T1, T2, T3, T4), deren Stromergiebigkeit jeweils in einem definierten Verhältnis zu der jeweiligen Stromergiebigkeit einer Anzahl von schaltungsinternen Referenzstromquellen (REF0...REF7) mit unterschiedlicher Stromergiebigkeit steht,
b) Vergleichen der jeweiligen Stromergiebigkeiten der schaltungsinternen Referenzstromquellen mit der des zu messenden Schaltungsteils (ST),
c) Bestimmen, welche der internen Referenzstromquellen (REF0...REF7) eine höhere und welche eine niedrigere Stromergiebigkeit als das zu messende Schaltungsteil (ST) haben und,
d) Bestimmen der Stromergiebigkeit des Schaltungsteils aus der in Schritt a) gemessenen Stromergiebigkeit der an einem Eingangs- (EA1, EA2) oder Ausgangsanschluß (AA1) angeordneten Stromquelle (T1, T2, T3, T4) sowie dem bekannten Verhältnis der Stromergiebigkeit der an einem Eingangsoder Ausgangsanschluß angeordneten Stromquelle zu den Stromergiebigkeiten der in Schritt c) bestimmten internen Referenzstromquellen.

## Claims

1. Integrated circuit (IS) having at least one circuit part (ST; NVM; NVM0...NVM7) whose current yield can be set, having a reference current source and a comparator device, **characterized in that**
- at least one current source (T1, T2, T3, T4) whose current yield can be measured from outside the integrated circuit (IS) is arranged at an input terminal (EA1, EA2) or output terminal (AA1) of the integrated circuit (IS),
- provision is made of a measuring apparatus (MV) having a number (determined by the desired measurement accuracy) of reference current sources whose current yields are different but are in a defined ratio to the current yield of the current sources (T1, T2, T3, T4) arranged at an input terminal (EA1, EA2) or output terminal (AA1), the measuring apparatus (MV) also having the at least one comparator device (VE), which can be supplied with both the current of the circuit part (ST; NVM; NVM0...NVM7) and the currents of the reference current sources (REF; REF0...REF7) and which is designed in such a manner that it detects which of the reference current sources (REF; REF0...REF7) has a higher or lower current yield than the circuit part (ST; NVM; NVM0...NVM7).

2. Integrated circuit according to Claim 1, **characterized in that** one of the reference current sources (REF4) has a current yield that corresponds approximately to the expected current yield of the circuit part (ST; NVM0...NVM7) to be measured and two further reference current sources (REF0, REF7) have current yields that correspond approximately to the upper and lower limits of the settability of the circuit part (ST; NVM0...NVM7) and the current yield of the further reference current sources (REF1, REF2, REF3, REF5, REF6) have values that lie between these limit values.

3. Integrated circuit according to Claim 1 or 2, **characterized**
**in that** the current source arranged at an input terminal (EA1, EA2) is a PMOS transistor (T1) whose source terminal is connected to the supply voltage (VDD), whose gate terminal is connected to earth and whose drain terminal is connected to the input terminal (EA1), and
**in that** the reference current sources (REF0...REF7) are likewise PMOS transistors whose respective source terminals can be connected to the supply voltage (VDD) and whose respective gate terminals are connected to earth and whose respective drain terminals form the outputs of the reference current sources (REF0...REF7).

4. Integrated circuit according to Claim 1 or 2, **characterized**
**in that** the current source arranged at an input terminal (EA2) is an NMOS transistor (T2) whose source terminal is connected to earth, whose gate terminal is connected to the supply voltage (VDD) and whose drain terminal is connected to the input terminal (EA2), and
**in that** the reference current sources (REF0...REF7) are likewise NMOS transistors whose respective source terminals can be connected to earth and whose respective gate terminals are connected to the supply voltage (VDD) and whose respective drain terminals form the outputs of the reference current sources (REF0...REF7).

5. Integrated circuit according to Claim 1 or 2, **characterized in that** the current source arranged at an output terminal (AA1) is the PMOS transistor (T3) or the NMOS transistor (T4) of a CMOS output driver (AT), and **in that** the reference current sources (REF0...REF7) are likewise PMOS or NMOS transistors whose respective source terminals can be connected to the supply voltage (VDD) or to earth and whose respective gate terminals are connected to earth or to the supply voltage (VDD) and whose respective drain terminals form the outputs of the reference current sources (REF0...REF7).

6. Integrated circuit according to one of Claims 1 to 5, **characterized**
**in that** the circuit part (ST) is formed by a number of identical parallel-connected circuit part simulations whose current-supplying output can be connected to the comparator device (VE) via a current divider that divides the current by the number.

7. Integrated circuit according to one of Claims 1 to 5, **characterized**
**in that** a different circuit part simulation (NVM0...NVM7) is assigned to each of the reference current sources (REF0...REF7).

8. Method for determining the current yield of at least one circuit part (ST) of an integrated circuit (IS), having the steps of:
a) measuring the current yield of a current source (T1, T2, T3, T4) that is arranged at an input terminal (EA1, EA2) or output terminal (AA1) of the integrated circuit and whose current yield is respectively in a defined ratio to the respective current yield of a number of circuit-internal reference current sources (REF0...REF7) having a different current yield,
b) comparing the respective current yields of the circuit-internal reference current sources with that of the circuit part (ST) to be measured,
c) determining which of the internal reference current sources (REF0...REF7) have a higher current yield and which have a lower current yield than the circuit part (ST) to be measured, and
d) determining the current yield of the circuit part from the current yield - measured in step a) - of the current source (T1, T2, T3, T4) arranged at an input terminal (EA1, EA2) or output terminal (AA1) and the known ratio of the current yield of the current source arranged at an input or output terminal to the current yields of the internal reference current sources determined in step c).

## Revendications

1. Circuit (IS) intégré ayant au moins une partie (ST; NVM; NVM0 ... NVM7) de circuit, dont le rendement en courant est réglable, une source de courant de référence et un dispositif comparateur, **caractérisé en ce que**
- Il est monté sur une borne (EA1, EA2) d'entrée ou sur une borne (AA1) de sortie du circuit (IS) intégré au moins une source (T1, T2, T3, T4) de courant, dont le rendement en courant peut être mesuré de l'extérieur du circuit (IS) intégré,
- Il est prévu un dispositif (MV) de mesure, qui a un nombre déterminé par la précision de mesure qui est souhaitée de sources de courant de référence, dont les rendements en courant sont différents mais sont dans un rapport défini avec le rendement en courant des sources (T1, T2, T3, T4) de courant montées sur la borne (EA1, EA2) d'entrée ou sur la borne (AA1) de sortie, le dispositif (MV) de mesure ayant en outre le au moins un dispositif (VE) comparateur auquel peuvent être envoyés tant le courant de la partie (ST ; NVM ; NVM0 ... NVM7) du circuit que les courants des sources (REF ; REF0 ... REF7) de courant de référence et qui est constitué de façon à détecter celle des sources (REF ; REF0 ... REF7) de courant de référence qui a un rendement en courant plus grand ou plus petit que la partie (ST ; NVM ; NVM0 ... NVM7) de circuit .

2. Circuit intégré suivant la revendication 1, **caractérisé en ce que** l'une des sources (REF4) de courant de référence a un rendement en courant qui correspond à peu près au rendement en courant auquel on s'attend de la partie (ST; NVM0 ... NVM7) de circuit à mesurer et deux autres sources (REFO, REF7) de courant de référence ont des rendements en courant qui correspondent à peu près à la limite supérieure et à la limite inférieure de la possibilité de réglage de la partie (ST ; NVM0 ... NVM7) de circuit et des rendements en courant des autres sources (REF1, REF2, REF3, REF5, REF6) de courant de référence ont des valeurs qui se trouvent entre ces valeurs limites.

3. Circuit intégré suivant la revendication 1 ou 2, **caractérisé**
**en ce que** la source de courant montée sur la borne (EA1), EA2) d'entrée est un transistor (T1) PMOS dont la borne de source est reliée à la tension (VDD) d'alimentation, dont la borne de grille est reliée à la masse et dont la borne de drain est reliée à la borne (EA1) d'entrée et
**en ce que** les sources (REF0 ... REF7) de courant de référence sont également des transistors PMOS dont les bornes de source respectives peuvent être reliées à la tension (VDD) d'alimentation et dont les bornes de grille respectives sont reliées à la masse et dont les bornes de drain respectives forment les sorties des sources (REF0 ... REF7) de courant de référence.

4. Circuit intégré suivant la revendication 1 ou 2, **caractérisé**
**en ce que** la source de courant montée sur la borne (EA2) d'entrée est un transistor (T2) NMOS dont la borne de source est reliée à la masse, dont la borne de grille est reliée à la tension (VDD) d'alimentation et dont la borne de drain est reliée à la borne (EA2) d'entrée et
**en ce que** les sources (REF0 ... REF7) de courant de référence sont également des transistors NMOS dont les bornes de source respectives peuvent être reliées à la masse et dont les bornes de grille respectives sont reliées à la tension (VDD) d'alimentation et dont les bornes de drain respectives forment les sorties des sources (REF0 ... REF7) de courant de référence.

5. Circuit intégré suivant la revendication 1 ou 2, **caractérisé en ce que** la source de courant, montée sur une borne (AA1) de sortie, est le transistor (T3) PMOS ou le transistor (T4) NMOS d'un étage (AT) de sortie CMOS, et **en ce que** les sources (REF0 ... REF7) de courant de référence sont également des transistors PMOS ou NMOS dont les bornes de source respectives peuvent être reliées à la tension (VDD) d'alimentation ou à la masse et dont les bornes de grille respectives sont reliées à la masse ou à la tension (VDD) d'alimentation et dont les bornes de drain respectives forment les sorties des sources (REF0 ... REF7) de courant de référence.

6. Circuit intégré suivant l'une des revendications 1 à 5, **caractérisé**
**en ce que** la partie (ST) de circuit est formée par un nombre de simulations de parties de circuit identiques montées en parallèle et dont la sortie fournissant du courant peut être reliée au dispositif (VE) comparateur par un diviseur de courant divisant le courant par le nombre.

7. Circuit intégré suivant l'une des revendications 1 à 5, **caractérisé**
**en ce que** chacune des sources (REF0 ... REF7) de courant de référence est associée à une simulation (NVM0 ... NVM7) différente de partie de circuit.

8. Procédé de détermination du rendement en courant d'au moins une partie (ST) d'un circuit (IS) intégré comprenant les stades :
a) on mesure le rendement en courant d'une source (T1, T2, T3, T4) de courant montée sur une borne (EA1, EA2) d'entrée ou sur une borne (AA1) de sortie du circuit intégré dont le rendement en courant se trouve en un rapport défini par rapport au rendement en courant respectif d'un certain nombre de sources (REF0... REF7) de courant de référence internes au circuit et ayant des rendements en courant différents,
b) on compare les rendements en courant respectifs des sources de courant de référence internes au circuit à celui de la partie (ST) de circuit à mesurer,
c) on détermine celle des sources (REF0 ... REF7) de courant de référence internes qui a un rendement en courant plus grand et celle qui a un rendement plus petit que la partie (ST) de circuit à mesurer, et
d) on détermine le rendement en courant de la partie de circuit à partir du rendement en courant mesuré au stade a) de la source (T1, T2, T3, T4) montée sur la borne (EA1, EA2) d'entrée ou sur la borne (AA1) de sortie, ainsi qu'à partir du rapport connu du rendement en courant de la source de courant montée sur une borne d'entrée ou sur une borne de sortie aux rendements en courant des sources de courant de référence internes déterminés au stade c).
